# EUROPEAN PATENT SPECIFICATION

(11) **EP 0 515 621 B1**
(45) Date of publication and mention of the grant of the patent: **27.08.1997**
(21) Application number: 92900836.5
(22) Date of filing: 21.11.1991
(51) Int. Cl.: B32B 27/00

(54) **IMPROVED COMPOSITE MATERIALS FOR ARCHITECTURAL STRUCTURAL END USE**
VERBESSERTE VERBUNDWERKSTOFFE FÜR DEN ARCHITEKTORISCHEN KONSTRUKTIVEN ENDVERBRAUCH
MATERIAUX COMPOSITES AMELIORES A USAGE STRUCTURAL ARCHITECTURAL

(30) Priority: 23.11.1990 US 617195
(43) Date of publication of application: 02.12.1992
(73) Proprietor: CHEMFAB CORPORATION, Merrimack, NH 03054 (US)
(72) Inventor: EFFENBERGER, John, A., Bedford, NH 03102 (US); KOERBER, Keith, G., Goffstown, NH 03045 (US); ENZIEN, Francis, M., Penacook, NH 03303 (US); CUSHMAN, Michael, P., New Boston, NH 03070 (US); PUNNETT, Milton, B., East Aurora, NY 14052 (US)
(74) Representative: Dubois-Chabert, Guy
(86) International application number: US9108675
(87) International publication number: WO9209429

(56) References cited:
- EP-A- 0 159 942
- US-A- 3 850 674
- US-A- 4 212 923
- US-A- 4 610 918
- US-A- 4 749 625
- US-A- 4 770 927

## Description

The present invention relates to textile products, and more particularly, to fiber reinforced flexible laminated fluoropolymer-containing composites suitable for outdoor, structural use, and to protective structures comprising flexible fluoropolymer-containing composites. The flexible fluoropolymer-containing composites of the present invention have particular utility as structural architectural materials, e.g. for building "shaded villages" in the desert, or domes over large sports stadia, churches, shopping malls, and the like, and in the fabricating of electromagnetic windows or radomes, and will be described in connection with such utility, although other utilities are contemplated.

Since their introduction in the early seventies, the use of flexible fluoropolymer-containing composites as "architectural materials" for constructing so-called "tensioned-fabric structures" has continuously grown. This surge in such application has been associated with the development of an advanced grade of flexible fluoropolymer-containing woven fiberglass composite materials having advantageous mechanical and solar-optical properties along with good soil-release behavior, virtual incombustibility and good weatherability. Fluoropolymer-coated flexible textile substrates, such a polytetrafluoroethylene (PTFE) coated fiberglass or the like, exhibit very good weathering and uniqueness of physical properties such as their very low surface free energy and good balance of solar optical characteristics, favoring their use in architectural structural applications. These properties, coupled with the composite material's inherently high strength to weight ratio, further favors their use in such structural applications.

Particularly important properties of fluoropolymer-coated flexible textile composites intended for architectural tensioned-fabric structural end use is their very low surface free energy and chemical inertness to the natural elements of rain, wind, snow and solar insulation and resistance to biological contamination. Specifically, the extremely low surface free energy of PTFE coated textile composites confers upon a structure made from such a fluoropolymer composite the ability to shed adventitious water and to resist soiling which would otherwise occur as the result of exposure over time to airborne smog, soot, aerosols, etc. which are ubiquitous in the outdoor environment.

It has been found that the surface free energy of PTFE coated fiberglass composites, as manufactured, is about 18-19 ergs/cm² (18-19.10⁻³ J/m²), rendering them highly hydrophobic. However, over time in the outdoors, it has been found that the surface free energy can increase to about 23 ergs/cm² (23.10⁻³ J/m²), with occasional areas as high as 28 ergs/cm² 28.10⁻³ J/m²). While 23 ergs/cm² (23.10⁻³ J/m²) still represents very good hydrophobicity, it represents a sub-optimal value given the inherent properties of PTFE, and may be unacceptably high in structural applications such as radomes where hydrophobicity is a key to microwave transmission. As a result, it is necessary to clean the structure periodically to restore initial appearance and hydrophobicity.

While not wishing to be bound by theory, it is believed that the increase in surface energy over time is related to the physical surface topography of the PTFE coated textile composites. It is known that the coating process itself may not produce a truly smooth, uniform and defect-free (i.e. microcracks, craters, pinholes, etc.) polymeric surface. A direct consequence of the somewhat microcracked surfaces inherent to these composites when produced by a coating methodology is the slow deterioration of such release properties and hydrophobicity. Dirt and microbiological growth can take a "foothold" in such microcracks, particularly as such cracks become larger over time and/or with thermal cycling (diurnal and seasonal). This behavior is discussed in "The Effects of Rain on a Radome's Performance", Microwave Journal, May 1986 (John A. Effenberger, Richard R. Strickland, Edward B. Joy).

In order to overcome this problem, it has been proposed to use a TFE copolymer to heal the microcracking of the PTFE in the surface of PTFR coated fiberglass composite intended for architectural use. While useful to a degree, the improvement obtained with such treatment does not completely prevent soiling, and to the extent that non-uniformity of coating, and coating defects occur, a surface with variable ability to resist soiling or to exhibit optimal hydrophobicity results, particularly over time in the outdoor environment.

Additionally, since one of the functions of the PTFE in such coated products is to protect the reinforcing glass fibers from the elements, particularly from liquid water, the presence of coating defects such as craters, pinholes, microcracks, etc. represents a compromise in the effective strength of the composite itself necessitating the use of elevated safety factors in designing with such material for structural use.

Another disadvantage associated with PTFE coated fiberglass composites intended for architectural tensioned-fabric structural end-use is the limited ability to incorporate into the composite materials aesthetic effects such as color. While pigmentation of the PTFE is possible, such pigmentation is limited by the deleterious effects of hard, mineral particulates on the effective strength of the reinforcements when incorporated into the coating formulations. Thus, the amount and location of pigment which can be added is severely limited. Additionally, because of the non-uniform topography of a woven reinforcement, and the limitations in the dip-coating process used to produce such composite materials, it is not possible to produce a dip-coated composite with a uniformly thin layer of pigment containing PTFE whereby to obtain uniformly intense coloration by reflected light and yet retain a high degree of light transmission.

Moreover, when color is introduced in a PTFE coating process, it is difficult to control both the uniformity and transmissivity of the coated product since the coatings tend to be thicker in the textile "windows" and thinner over the textile "knuckles". Thus, while available for industrial PTFE coated products, colors other than white have not played a significant role in the aesthetically more demanding architectural applications of the PTFE coated products.

Generally, the level of pigmentation required to achieve a uniformly aesthetic effect in a coated product is high enough to substantially reduce the overall light transmission of such composites. This is detrimental to its intended use, for example, as a skylight or solar luminaire.

It is, therefore, an object of the present invention to provide a flexible textile composite material for tensioned-fabric structural end-use which overcomes the aforesaid and other disadvantages of the prior art, and more particularly to provide flexible fluoropolymer composite materials which are particularly suited to outdoor, structural end-use, and which are characterized by durable hydrophobicity, an ability to resist the deleterious effects of liquid water, and compatibility with architectural design strategies aimed at good light transmission and intense coloration by reflected light.

EP-A-0159942 discloses a composite material comprising a fibrous reinforced element and a tetrafluoroethylene polymer coating coating. A PTFE film comprising one or more additives is laminated to the composite material

### SUMMARY OF THE INVENTION

In accordance with the present invention, there is provided a flexible, laminated, reinforced textile composite material for structural end-use comprising a fibrous reinforced load-bearing component, said load-bearing component comprising a fibrous reinforced fluoropolymer textile composite material, at least one surface of said composite material being covered, at least in part, by a hydrophobic protective film layer laminated thereto. In a preferred embodiment of the invention, the hydrophobic protective film comprises PTFE and may include one or more additives such as a colorant or dyestuff, or a bactericide such as a fungicide, mildewicide, or the like.

Other objects, advantages and features of the present invention will be apparent and readily understood from the following description of the invention, taken in conjunction with the drawings, in which like reference characters refer to like parts, and wherein:

### DESCRIPTION OF THE DRAWINGS

Fig. 1 is a side elevational view, in cross section, of a laminated textile composite material made in accordance with the present invention;
Fig. 2 is a side elevational view, in cross section, of an alternative form of laminated textile composite material made in accordance with the present invention;
Fig. 3 is a side elevational view, partly in section, showing the use of a laminated textile composite material made in accordance with a preferred embodiment of the present invention as a structural element in a domed structure; and
Figs. 4 and 5 illustrate transmittance and reflectance of a laminated textile composite material made in accordance with the present invention over a range of electromagnetic radiation between 190 µm and 900 µm.

### DETAILED DESCRIPTION OF THE INVENTION

As used herein, the term "textile" shall include naturally occurring and synthetic woven or non-woven materials such as a knit fabric. Any suitable textile material capable of withstanding processing temperatures and able to sustain the static and dynamic mechanical loads in a structure may be employed as the reinforcing material for of load bearing composite in accordance with the present invention. Examples, include, inter alia, fiberglass, ceramics, graphite (carbon), PBI (polybenzimidazol), polyaramides such as KEVLAR (registered trademark) and NOMEX (registered trademark), polyolefins such as TYVEK (registered trademark), polyesters such as REEMAY (registered trademark), polyamides, polyimides, thermoplastics such as KYNAR (PVF₂) (registered trademark) and TEFZEL (ETFE) (registered trademark), polyethersulfones, polyethermides, polyetherketones, novoloid phenolic fibers such as KYNOL (registered trademark), PTFE, cotton, and other natural and synthetic fibers. The reinforcing material may comprise a yarn, filament, monofilament, slit film or the like assembled as a textile. The reinforcing material also may comprise a metallic material such as steel wire, mesh or the like. Preferably the reinforcing material comprises fiberglass.

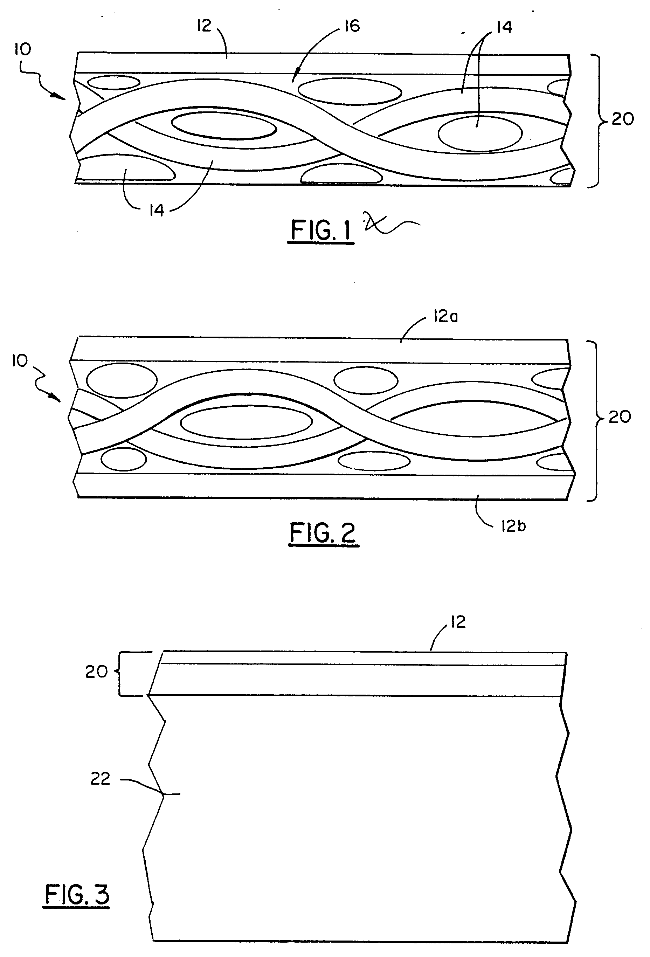

Referring in particular to Fig. 1 of the drawings, there is illustrated a preferred form of a laminated textile composite material 20 made in accordance with the present invention. The textile product comprises a first, load-bearing composite element 10, having a second layer 12 formed of a polytetrafluoroethylene-containing film layer laminated to the load bearing element 10.

The composite textile substrate layer 10 is formed by coating or impregnating a textile substrate, e.g. fiberglass 14, with PTFE 16 or the like in known manner, for example, by applying the PTFE from a suspension and fusing the applied PTFE for example, in accordance with the teachings of U.S. Patent 3,928,703 to Cook.

The hydrophobic protective film layer 12 preferably comprises one or more preformed films, at least one of which comprises a TFE polymer, preferably PTFE, which may be preformed by a variety of known techniques such as melt extrusion, melt casting, skiving and paste extrusion. Additional film elements comprising, for example, the thermoplastic terpolymer of TFE, HFP and VF₂ may be employed in combination with the PTFE film.

If desired, one or a mixture of additives may be included in the hydrophobic protective film element 12 for producing a desired effect. For example, a colorant or dye stuff may be incorporated into the film material, e.g. prior to forming the film so that the resultant film comprises a uniformly dispersed colorant or dye. Also, if desired, one or a mixture of fungicides, bactericides and mildewicides or other biocidal agents may be incorporated into the film so as to result in a film having enhanced resistance to biological contamination.

Referring to Fig. 2, the laminated textile composite material includes a load-bearing composite textile substrate element 10, sandwiched between hydrophobic protective film elements 12A and 12B, each formed of a polytetrafluoroethylene-containing film.

Fig. 3 shows the use of the laminated textile composite material 20 made in accordance with the present invention, as a structural architectural element, for example, in forming a dome. As seen in Fig. 3, the laminated composite material is supported by a supporting frame member 22 with the film element 12 facing the outdoor environment.

The invention, and its advantages may be further seen by the following non-limiting examples which illustrate a preferred method of forming a flexible reinforced laminated composite textile material in accordance with the present invention. The overall process is as follows:

First, the load-bearing textile composite is formed by impregnating or coating a fabric layer 10 with a fluoropolymer such as PFTE, TFB (registered trademark) Hoechst), KEL-F (registered trademark) (3M), or a blend thereof, and the impregnating material is fused by heating the coated/impregnated material.

In Example I, film elements 12A and 12B comprise separately formed cast PTFE films with a thickness of approximately 4.0 mils, (1,016.10⁻⁴ m).

In Example II, a colorant is incorporated into the PTFE film element.

In Example III, the film layers 12A and 12B comprise separately formed cast 1.7 mil (4,31.10⁻⁵ m) PTFE films in which the outermost 0.4 mils (1,016.10⁻⁵ m) on one face remain unfused initially.

### EXAMPLE I

### A. PRODUCTION OF LAMINATE

A PTFE coated glass fabric suitable for outdoor, structural end-use (CHEMFAB's RAYDEL M-26 electromagnetic window composite) was employed as a substrate element 10 along with a 4 mil (1,016.10⁻⁴ m) perfluoropolymer film element 12 to create a laminated composite 20 in accordance with the present invention. Lamination was facilitated by first applying a top coat of PFA resin to the PTFE coated glass fabric to provide a melt-bondable surface. The perfluoropolymer film (DF-1700 PFA available from Chemical Fabrics Corporation, "CHEMFAB") consisted of 3.8+ mils (9,65.10⁻⁵ m) of PTFE and 0.1+ mils (2,54.10⁻⁶ m) of PFA on one of its surfaces.

Lamination was accomplished by passing a "sandwich" of the film on both sides of the top-coated substrate such that the film/substrate interface is PFA-to-PFA between a succession of heated platens which were set at 400, 600 and 700 degrees F, (204,4°C; 315,5°C; 371,1°C) and finally between cooling platens set at 55 degrees F (12,7°C). At a feed rate of 1.5 ft/min (7,62.10⁻³ m/s), the exiting laminate had a temperature of 440-470 degrees F (226,6°C-243,3°C). The applied pressure in the platens was less than 4 psi (27,5.10³ Pa), and the laminating "work" (coated substrate plus films) was supported between lightly coated TCGF (registered trademark) carriers as it passed between the platens.

Properties of the laminated composite (LEOD-87-3) thus prepared are as follows:

**TABLE I**

| PROPERTY | UNITS | VALUE^{(b)} |
|---|---|---|
| Weight^{(a)} | oz/y² | 36.0 +/- 0.1 (133,9 +/- 0,3.10⁻³ g/cm²) |
| Thickness | .001 in | 26.5 +/- 0.3 (67,31 +/- 0,76.10⁻⁵ m) |
| Tensile Strength | lb/in | |
| warp | | 515 +/- 16 (35,48 +/- 1,1.10⁵ Pa) |
| fill | | 496 +/- 29 (34,17 +/- 2.10⁵ Pa) |
| Tear Strength | (lb) | |
| warp | | 40 +/- 2 (18,14 +/- 0,90 kg) |
| fill | | 55 +/- 1 (24,95 +/- 0,45 kg) |

| | | |
|---|---|---|
| (a) The fiberglass reinforcement of the coated substrate weighed 9 oz/y² (33,5 g/cm²) with warp and fill yarns of ECC (registered trademark) 150 2/2 fiberglass at a count of 28 x 29 respectively. | | |
| (b) Mean value and standard deviation based on n = 10 (except for weight and thickness for which n = 4). | | |

These are consistent with expectations given that the coated substrate weighed 22.5 oz/y² 83,76.10⁻³ g/cm² and was 18.0 mils (45,72.10⁻⁵ m) in thickness.

It is well known that the success of PTFE coated fiberglass in outdoor structural end-use is largely due to its inertness to the ubiquitous elements associated with the outdoor environment: namely sunlight (particularly ultra-violet radiation), water (liquid and vapor), and oxidizing gases (oxygen and "smogs"), over a significant range of temperatures.

Experimental data (E. Takabatake; Nitto CHEMFAB Co., Ltd.; Proceedings of the International Association of Shell Structures; Dresden, Germany, September 1990) has confirmed that deterioration of the strength of such PTFE coated fabrics may be accelerated by immersion of such composites in water at elevated temperature. Indeed, liquid water is believed to be a significant causative agent for the slow mechanical deterioration of such composites in outdoor structural use. Real-time weathering data has indicated that about 25% of the tensile strength of such coated composites can be lost after fifteen years. Since such deterioration necessitates an increase in mechanical design safety factors governing the outdoor structural use of such composites, this will in general translate into the need for heavier, stronger and more costly composites. Thus, there is a significant premium attached to the use of PTFE coated composites in such use.

### B. EVALUATION OF LAMINATE

In order to evaluate the laminated PTFE composite of the present invention for its ability to better resist the mechanical deterioration induced by liquid water, the laminate PTFE composite of Example I, Part A, was subjected to the action of concentrated, aqueous, alkaline solutions. The elevated pH was employed so that any hydrolysis due to liquid penetration of the composite would be accelerated.

In a preliminary evaluation, a box-like container was fabricated from the laminate prepared in Example I, Part A, and filled with 40% aqueous NaOH. The container was then placed in a hot water bath to maintain the temperature of its contents at 60-70 degrees C for 8-9 hours on each of five days with a total exposure extending over seven days. No effect of such exposure was observed on either the tensile or tear strength of the laminate.

Subsequently, an apparatus was set up to allow a one-sided exposure of this same laminate to both a 50% aqueous NaOH solution at 60 +/- 5 degrees C. Also included as a control in the evaluation was a PTFE coated fiberglass composite, CHEMFAB's DARLYN® 1100, which is noted for its outstanding inertness in hot, corrosive, environments.

As may be seen from the data of Table II, the laminated product prepared in accordance with Example I, Part A (based upon a film comprised of PTFE as well as a coated substrate comprised of PTFE) is clearly superior in its ability to remain unaffected by exposure to liquid water even at elevated pH. This is presumably a reflection of the inability of the liquid water to penetrate to the reinforcement due to the more perfect state of consolidation of the PTFE polymeric matrix when incorporated into the composite as a film.

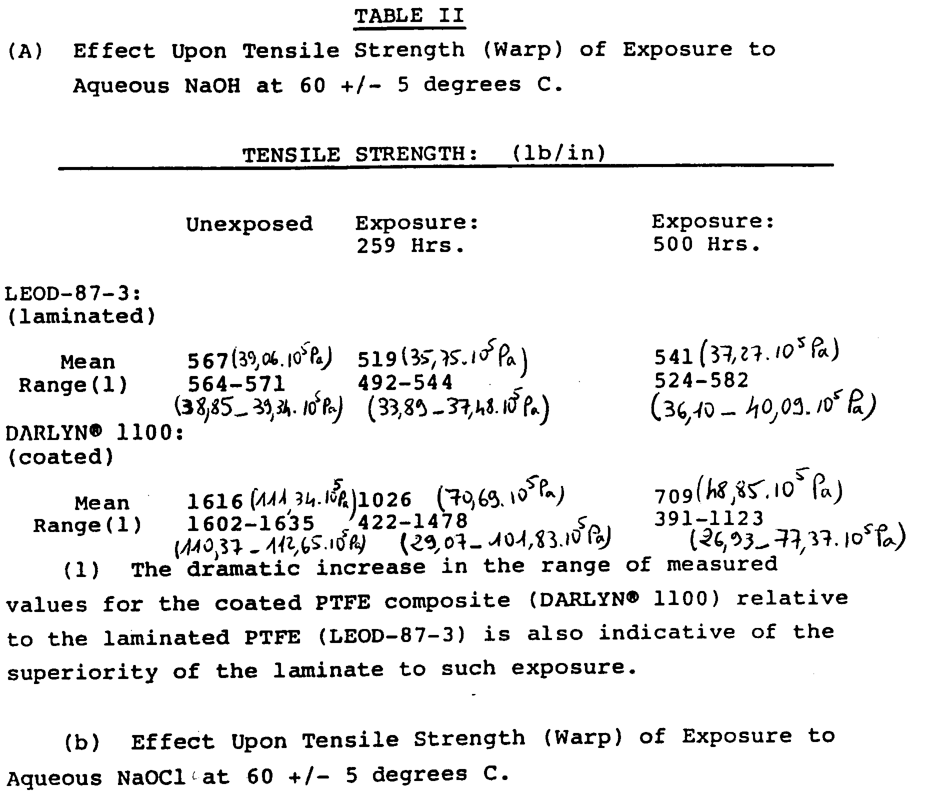

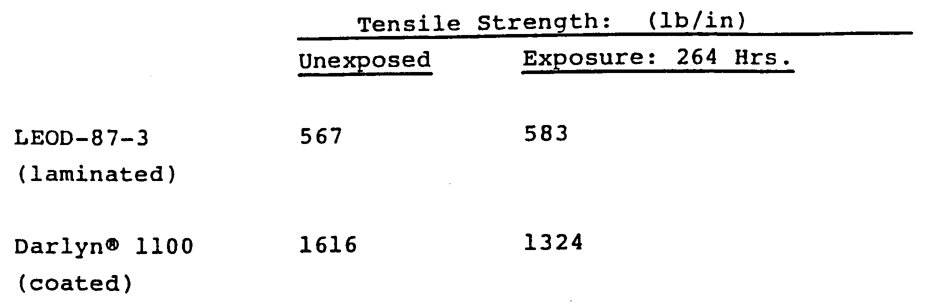

### EXAMPLE II

### A. PRODUCTION OF LAMINATE

The films employed on each face of this laminate were multilayered PTFE films with one face comprised of PTFE in an unfused condition to promote lamination by the method of European application EP 419 594, assigned to the common assignee. One film was an all PTFE film; the other film was a multi-layer construction with 0.4 mils of clear PTFE, followed by 0.2 mils of PTFE containing 2% by weight of red iron oxide, and followed again by 0.2 mils of PTFE containing 5% "Velveteen" black carbon. The final 0.2 mils is the clear, unfused PTFE. Thus, the pigment determining the hue of reflected light appear in two layers constituting only 0.4 mils of the overall thickness of the PTFE.

These multilayered films were laminated to a previously formed PTFE coated fabric containing about 70% by weight PTFE and 4.0 ox/y² of fiberglass. In accordance with European application EP 419 594, the outermost 1.24 oz/y² of PTFE were left unfused to serve as a bonding layer for the films.

### B. EVALUATION OF LAMINATE

The final laminate weighs 15 oz/y² and has a thickness of 10.0 mils with a tensile strength of about 200 x 200 lb/in.

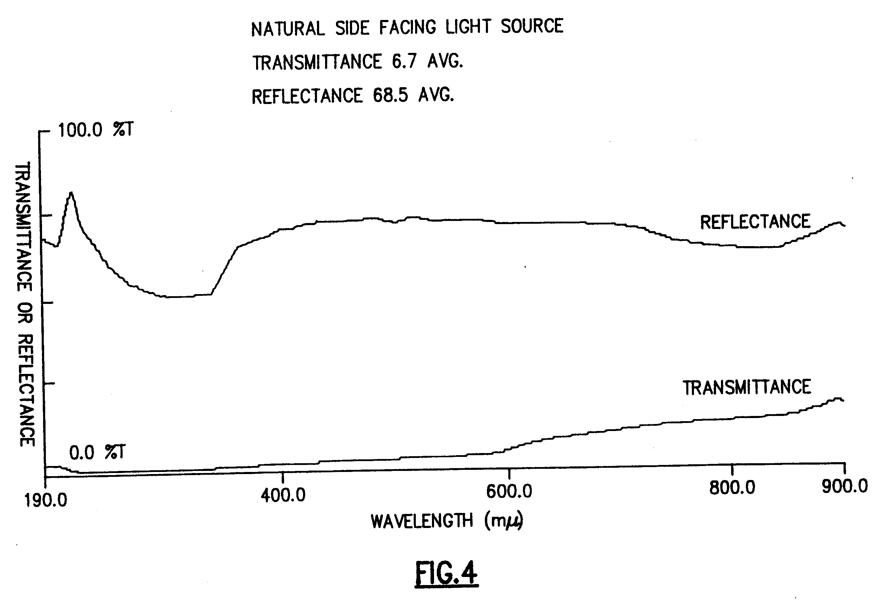

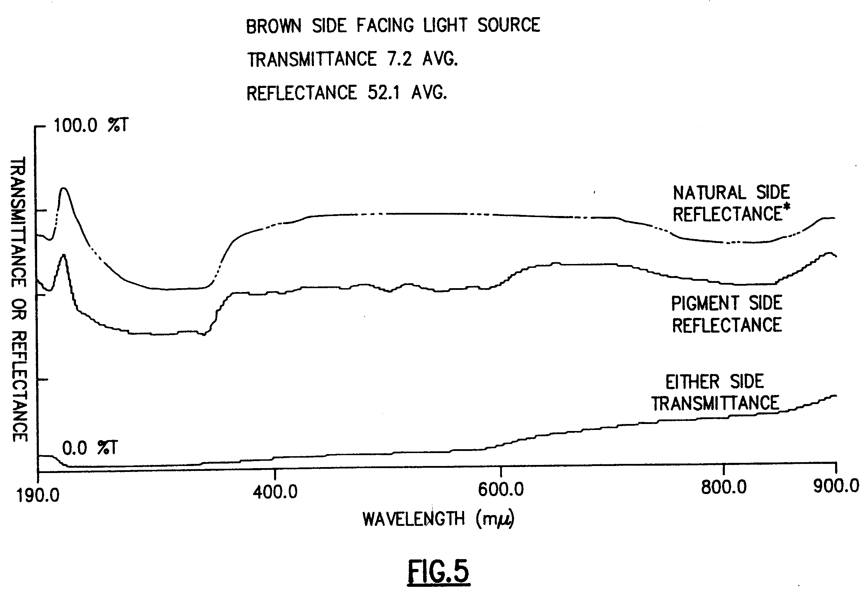

The resulting laminate was tested for light transmission and reflectivity and the results plotted in Figs. 4 and 5. An overall transmission of about 7% was observed. This transmission level is typical of that obtained in a domed stadium based upon a coated PTFE composite such as SHEERFILL® II from CHEMFAB.

However, the reflectance from one side (the "natural" or unpigmented side) is 68.5% while that from the side which has been laminated with a brown pigmented film is 52.1%.

This demonstrates the ability to employ pigmented films to differentially (face to face) control the overall "shading" (transmission) obtainable from a given composite, as well as the color and level of reflected light. This is a highly desirable feature in a skylight material.

Also, providing hydrophobic films on both sides of the textile composite fabric will also render both surfaces of the installed composite fabric hydrophobic and soil resistant.

### EXAMPLE III

### A. PRODUCTION OF LAMINATE

The fiberglass reinforcement weight 4 oz/y² and is based on plain woven D450 2/2 yarns at a count of 38 x 36 (warp and fill). A PTFE coating of 9.8 oz/y² was applied by well known dip coating methodology, except that an additional 1.2 oz/y² was applied in a last pass which remained unfused since the highest processing temperature on that pass was 595 degrees F (312,7°C). A specific gravity of 1.49 +/- .01 was employed for each dip using Teflon® 3013 and TD 3313 dispersions.

The film used in lamination was 1.7 mils (4,31.10⁻⁵ m) thick of which the outermost 0.4 mils (1,016.10⁻⁵ m) on one face remained unfused. A layer of film was laminated to each face of the coated substrate, mediated by the unfused PTFE surfaces of each component using the lamination techniques described in Example 1.

### B. EVALUATION OF LAMINATE

The final laminate was tested in a Q-UV(B) accelerated weathering tester, the contact angle to water determined by means of a Gonometer, and the results reported in Table III.

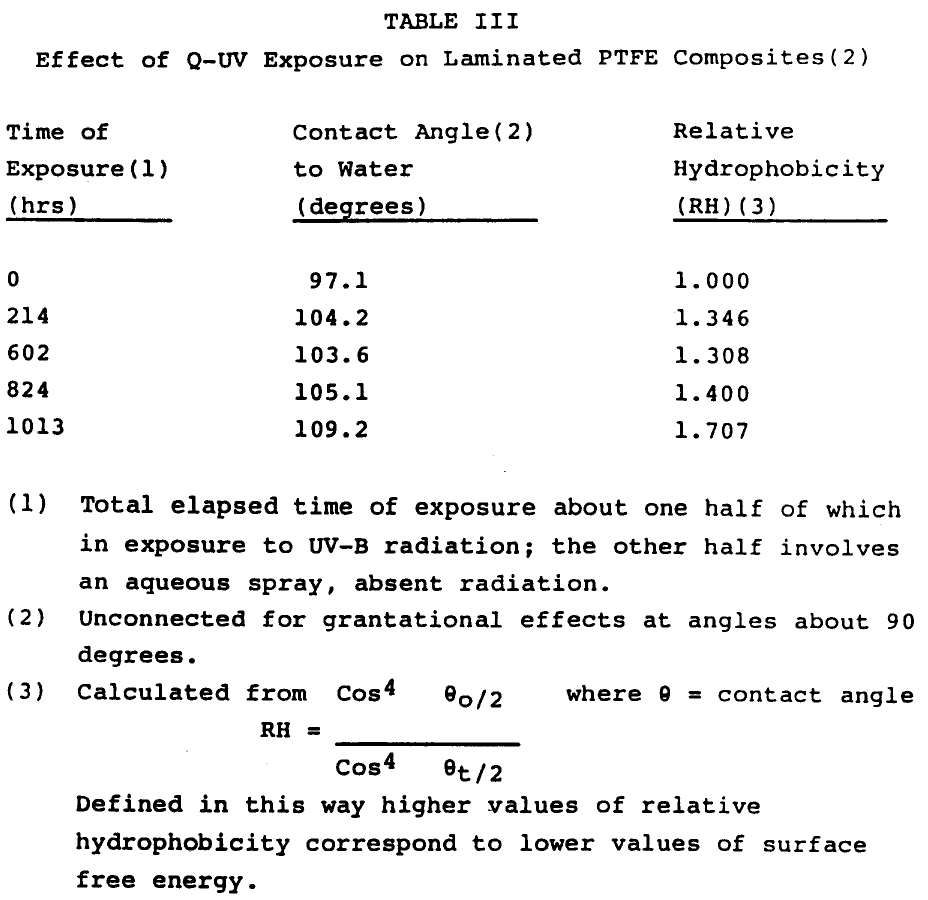

This increase in relative hydrophobicity upon exposure in a Q-UV(B) accelerated weathering tester is unlike the decrease reported for conventionally coated PTFE composites.

The observed durable hydrophobicity makes such a product an outstanding structural composite based on its relative low surface energy and therefore soil-releasing capability.

## Claims

1. A structure comprising a supporting frame member (22) holding, under tension, a laminated textile composite material (20) which is supported by said supporting frame member (22) and which comprises a fibrous reinforced element (10) for bearing a load, formed by a textile substrate (14) and a hydrophobic tetrafluoroethylene polymer coating component (16), characterized in that it comprises at least one preformed hydrophobic protective film element (12) comprising a tetrafluoroethylene polymer and including one or a mixture of additives selected from a colorant, a dyestuff and a biological agent, said protective film element (12) being laminated to at least one surface of said fibrous reinforced element (10).

2. A structure as claimed in claim 1, characterized in that said fibrous reinforce load-bearing element (10) is sandwiched between and laminated to, two hydrophobic protective film elements (12a, 12b) .

3. A structure according to claim 1 or 2, characterized in that said biological agent comprises a bactericide or a mildewicide.

4. A structure according to any of claims 1 to 3, characterized in that said hydrophobic protective film element (12) comprises a fluoropolymer film, preferably a cast polytetrafluoroethylene film, a skived polytetrafluoroethylene film, or a paste-extruded polytetrafluoroethylene film.

5. A structure according to any of claims 1 to 4, characterized in that said fibrous reinforced load-bearing element (10) comprises a textile material selected from natural and synthetic fibers, preferably fiberglass.

6. A structure according to any of claims 1 to 4, characterized in that said fibrous reinforced load-bearing element (10) is selected from a metal, a graphite and a ceramic.

7. A structure according to any of claims 1 to 6, characterized in that said fibrous reinforced load-bearing element (10) is in the form of a fiber, a filament, a slit film or a yarn, assembled as a textile.

8. A structure according to any of claims 1 to 7, characterized in that said hydrophobic protective film element (12, 12a, 12b) comprises a plurality of film elements laminated to one another.

9. A structure according to claim 8, characterized in that the outer-most film element of the hydrophobic protective film element (12) comprises polytetrafluoroethylene and in that one or more film elements interior of said outer-most element comprises one or a mixture of colorants, dyestuffs and biological agents.

## Patentansprüche

1. Anordung mit einem Tragrahmen (22), der unter Spannung ein laminiertes textiles Verbundmaterial (20) hält, welches von dem Tragrahmen (22) gestützt wird und ein faserverstärktes Element (10) zum Tragen einer Last umfaßt, das aus einem Textilsubstrat (14) und einer Beschichtungskomponente (16) aus einem hydrophoben Tetrafluorethylenpolymer gebildet ist, dadurch gekennzeichnet, daß sie mindestens ein vorgeformtes Element (12) in Form einer hydrophoben Schutzfolie umfaßt, die ein Tetrafluorethylenpolymer aufweist und einen Zusatz oder ein Gemisch von Zusätzen einschließt, der bzw. die aus einem Färbemittel, einem Farbstoff und einem biologischen Mittel ausgewählt ist bzw. sind, wobei das Schutzfolienelement (12) mit mindestens einer Oberfläche des faserverstärkten Elements (10) laminiert ist.

2. Anordnung nach Anspruch 1, dadurch gekennzeichnet, daß das faserverstärkte, lasttragende Element (10) nach Art eines Sandwiches zwischen zwei hydrophobe Schutzfolienelemente (12a, 12b) eingeschoben und mit diesen laminiert ist.

3. Anordnung nach Anspruch 1 oder 2, dadurch gekennzeichnet, daß das biologische Mittel ein Bakterizid oder ein Schimmelbekämpfungsmittel umfaßt.

4. Anordnung nach einem der Ansprüche 1 bis 3, dadurch gekennzeichnet, daß das hydrophobe Schutzfolienelement (12) eine Fluorpolymerfolie, vorzugsweise eine gegossene Polytetrafluorethylenfolie, eine Polytetrafluorethylen-Spaltfolie oder eine extrudierte Polytetrafluorethylenfolie umfaßt.

5. Anordnung nach einem der Ansprüche 1 bis 4, dadurch gekennzeichnet, daß das faserverstärkte, lasttragende Element (10) ein Textilmaterial umfaßt, das aus Natur- und Synthesefasern, vorzugsweise Glasfasern ausgewählt ist.

6. Anordnung nach einem der Ansprüche 1 bis 4, dadurch gekennzeichnet, daß das faserverstärkte, lasttragende Element (10) aus Metall, Graphit und Keramik ausgewählt ist.

7. Anordnung nach einem der Ansprüche 1 bis 6, dadurch gekennzeichnet, daß das faserverstärkte, lasttragende Element (10) in Form einer Faser, eines Filaments, einer Spaltfolie oder eines Garns, jeweils zu einem Textil zusammengesetzt, vorliegt.

8. Anordnung nach einem der Ansprüche 1 bis 7, dadurch gekennzeichnet, daß das hydrophobe Schutzfolienelement (12, 12 a, 12 b) mehrere miteinander laminierte Folienelemente umfaßt.

9. Anordnung nach Anspruch 8, dadurch gekennzeichnet, daß das äußerste Folienelement des hydrophoben Schutzfolienelements (12) Polytetrafluorethylen umfaßt und daß eines oder mehrere der inneren Folienelemente, die weiter innen liegen als das äußerste Element, ein Färbemittel, einem Farbstoff oder ein biologisches Mittel oder ein Gemisch davon enthalten.

## Revendications

1. Structure comprenant un élément formant châssis de support (22) retenant, sous tension, une matière composite textile stratifiée (20) qui est supportée par ledit élément formant châssis de support (22) et qui comprend un élément renforcé de fibres (10) pour supporter une charge, formée par un substrat textile (14) et par un composant formant revêtement en polymère tétrafluoréthylène (16), caractérisée en ce qu'elle comprend au moins un élément formant film protecteur hydrophobe préformé (12) comprenant un polymère tétrafluoréthylène et incluant un additif ou un mélange d'additifs choisi(s) parmi un colorant, une matière colorante et un agent biologique, ledit élément formant film protecteur (12) étant stratifié sur au moins une surface dudit élément renforcé de fibres (10).

2. Structure selon la revendication 1, caractérisée en ce que ledit élément supportant la charge, renforcé de fibres, (10) est pris en sandwich entre deux éléments formant films protecteurs hydrophobes (12a, 12b) et est stratifié sur ces derniers.

3. Structure selon la revendication 1 ou 2, caractérisée en ce que ledit agent biologique comprend un bactéricide ou un anti-moisissure.

4. Structure selon l'une quelconque des revendications 1 à 3, caractérisée en ce que ledit élément formant film protecteur hydrophobe (12) comprend un film de polymère fluoré, de préférence un film moulé de polytétrafluoréthylène, un film découpé en lamelles de polytétrafluoréthylène, ou un film de pâte extrudée de polytétrafluoréthylène.

5. Structure selon l'une quelconque des revendications 1 à 4, caractérisée en ce que ledit élément supportant la charge, renforcé de fibres (10), comprend une matière textile choisie parmi les fibres naturelles et synthétiques, de préférence les fibres de verre.

6. Structure selon l'une quelconque des revendications 1 à 4, caractérisée en ce que ledit élément supportant la charge, renforcé de fibres (10), est choisi parmi un métal, un graphite et une céramique.

7. Structure selon l'une quelconque des revendications 1 à 6, caractérisée en ce que ledit élément supportant la charge, renforcé de fibres (10), est sous la forme d'une fibre, d'un filament, de bandelettes ou de fils, assemblés comme un textile.

8. Structure selon l'une quelconque des revendications 1 à 7, caractérisée en ce que ledit film protecteur hydrophobe (12, 12a, 12b) comprend une pluralité d'éléments formant films stratifiés les uns aux autres.

9. Structure selon la revendication 8, caractérisée en ce que l'élément formant film le plus extérieur de l'élément formant film protecteur hydrophobe (12) comprend du polytétrafluoréthylène et en ce qu'un ou plusieurs éléments formant films intérieurs audit élément le plus extérieur comprennent un mélange de colorants, de matières colorantes (dyestaffs) et d'agents biologiques.
